# EUROPÄISCHE PATENTSCHRIFT

(11) **EP 0 772 048 B1**
(45) Veröffentlichungstag und Bekanntmachung des Hinweises auf die Patenterteilung: **22.12.1999**
(21) Anmeldenummer: 95117123.0
(22) Anmeldetag: 31.10.1995
(51) Int. Cl.: G01R 1/073

(54) **Vorrichtung zum Prüfen von Leiterkarten und/oder Flachbaugruppen**
Test means for printed circuits and/or flat assemblies
Dispositif de test de circuits imprimés et/ou des circuits plats

(43) Veröffentlichungstag der Anmeldung: 07.05.1997
(73) Patentinhaber: ALCATEL, 75008 Paris (FR)
(72) Erfinder: Keune, Andreas, D-29227 Celle (DE); Kellermann, Uwe, D-30451 Hannover (DE)
(74) Vertreter: Döring, Roger, Dipl.-Ing.

(56) Entgegenhaltungen:
- DE-A- 3 529 207
- US-A- 5 247 249

## Beschreibung

Die Erfindung bezieht sich auf eine Vorrichtung zum Prüfen von Leiterkarten und/oder Flachbaugruppen für elektrische Schaltungen, bei welcher in einem Gehäuse mindestens eine mit Kontaktnadeln unterschiedlicher Länge bestückte Trägerplatte angeordnet ist, bei welcher in einer oberhalb der Trägerplatte liegenden Deckplatte mindestens eine Aufnahme für einen als Leiterkarte oder Flachbaugruppe ausgebildeten Prüfling angebracht ist, bei welcher eine Einheit zur Erzeugung von Unterdruck zum Heranziehen des Prüflings an die Kontaktnadeln vorgesehen ist und bei welcher ein quer zur Bewegungsrichtung des Prüflings zwischen zwei Endstellungen bewegbarer, mit auf einer Seite rechtwinklig abstehenden Distanzstücken ausgerüsteter Schieber angebracht ist, durch welchen der Weg des durch Erzeugung des Unterdrucks aus seiner Ruhestellung bewegten Prüflings nach Maßgabe der unterschiedlichen Länge der Kontaktnadeln in zwei unterschiedlichen Ebenen begrenzbar ist (DE-C-3 529 207).

Derartige Vorrichtungen dienen zum vollautomatischen Prüfen von Leiterkarten bzw. Flachbaugruppen. Der Einfachheit halber werden im folgenden nur noch die Leiterkarten erwähnt. Mit einer solchen Vorrichtung werden beispielsweise der sogenannte Incircuit-Test und der Funktionstest einer fertig bestückten Leiterkarte durchgeführt. Die Deckplatte mit einer in der Aufnahme angeordneten Leiterkarte wird dazu mittels Unterdruck an die Trägerplatte heran gezogen, bis die Kontaktnadeln der Trägerplatte an der Leiterkarte anliegen.

Vorrichtungen, mit der beide Tests nacheinander durchgeführt werden können, werden beispielsweise von der US-Firma Virginia Panel Corporation, Waynesboro, VA, vertrieben. In dem Gehäuse dieser Vorrichtung sind unter der Trägerplatte ein funktionsfähiger Prototyp des Prüflings und eine umfangreiche Elektronik mit der Schnittstelle zum Anschluß eines Testsystems bzw. eines Rechners und für andere Zusatzfunktionen angeordnet sein.

Eine entsprechende Vorrichtung ist auch aus der eingangs erwähnten DE-C-3 529 207 bekannt. In der Trägerplatte dieser Vorrichtung sind Kontaktnadeln unterschiedlicher Länge angebracht. Die Deckplatte mit der Aufnahme für eine Leiterkarte kann mittels des Unterdrucks in zwei unterschiedliche Ebenen gebracht werden. In der unteren Ebene, in der alle Kontaktnadeln an der Leiterkarte anliegen, wird beispielsweise der Incircuit-Test durchgeführt. In der oberen, dann für den Funktionstest bestimmten Ebene, liegen nur die längeren Kontaktnadeln an der Leiterkarte an. Zur Einstellung der oberen Ebene ist ein mit Distanzstücken versehener, zwischen zwei Endstellungen bewegbarer Schieber vorhanden. Er liegt bei dieser bekannten Vorrichtung auf der Trägerplatte auf und ist durch an derselben angebrachte Führungen geführt. Er kann durch einen Elektromotor zwischen seinen beiden Endstellungen bewegt werden.

Eine weitere derartige Vorrichtung ist US-A-5 247 249 zu entnehmen.

In neuerer Zeit werden beispielweise von der US-Firma Hewlett-Packard unter der Bezeichnung 307X Vorrichtungen zum Testen von Leiterkarten vertrieben, die dem heutigen Standard auf diesem technischen Sachgebiet mit sehr kurzen Test-Zeiten entsprechen. Zur Ausnutzung aller durch einen modernen Rechner gegebenen Möglichkeiten, ist bei diesen Vorrichtungen nahezu die gesamte Fläche der Trägerplatte mit Kontaktnadeln bestückt. Es steht damit auf der Trägerplatte kein Platz zur Anbringung eines zwischen zwei Endstellungen bewegbaren Schiebers zur Verfügung. Zur Durchführung der erwähnten Tests wird bei dieser modernen Vorrichtung mit entsprechender Anschaltung der Kontaktnadeln an dafür vorgesehene Geräte beispielsweise der Incircuit-Test für Leiterkarten durchgeführt werden. Bei einer anderen Beschaltung der Kontaktnadeln kann die Vorrichtung für den Funktionstest verwendet werden. Für die beiden Tests werden in der Praxis zwei getrennte Vorrichtungen eingesetzt werden.

Der Erfindung liegt die Aufgabe zugrunde, die eingangs geschilderte Vorrichtung so zu gestalten, daß sie auch bei nahezu vollständig mit Kontaktnadeln bestückter Trägerplatte zur automatischen Durchführung sowohl des Incircuit-Tests als auch des Funktionstests geeignet ist.

Diese Aufgabe wird gemäß der Erfindung dadurch gelöst, daß der Schieber an der Unterseite der die Aufnahme für den Prüfling tragenden Deckplatte angebracht ist.

Mit der Anbringung des Schiebers an der Unterseite der Deckblatte ist es auf einfache Weise möglich, den an sich bekannten und bewährten Schieber zur Einstellung von zwei unterschiedlichen Prüfebenen auch dann einzusetzen, wenn in der Vorrichtung eine durch Kontaktnadeln fast vollständig belegte Trägerplatte verwendet ist. Mit der Anbringung des Schiebers an der Unterseite der Deckplatte befindet sich derselbe an einem Ort, an dem nicht nur Platz zur Verfügung steht, sondern an dem er auch sehr einfach montiert werden kann. Die Distanzstücke des Schiebers ragen in dessen jeweiliger Stellung in Lücken zwischen den Kontaktnadeln hinein. Freiräume für die Distanzstücke bei der Bewegung des Schiebers werden nicht benötigt, da die Distanzstücke bei dieser Bewegung nicht in den Bereich der Kontaktnadeln eingreifen. Bei der Montage des Schiebers an der Deckplatte braucht bis auf die maßgenaue Anordnung und Justage desselben keine besondere Sorgfalt angewendet zu werden. Die Deckplatte trägt nämlich keine Kontaktnadeln bzw. Hülsen zur Aufnahme derselben, die möglicherweise beschädigt werden könnten. Sie ist auch frei von irgendwelchen anderen Funktionselementen.

Das macht sich auch dann vorteilhaft bemerkbar, wenn der Schieber aus irgendwelchen Gründen gegen einen neuen Schieber ausgetauscht werden muß.

Ein Ausführungsbeispiel des Erfindungsgegenstandes ist in den Zeichnungen in stark schematisierter Form dargestellt.

Es zeigen:
Fig. 1 einen Querschnitt durch eine Vorrichtung nach der Erfindung.
Fig. 2 eine Draufsicht auf die Vorrichtung.

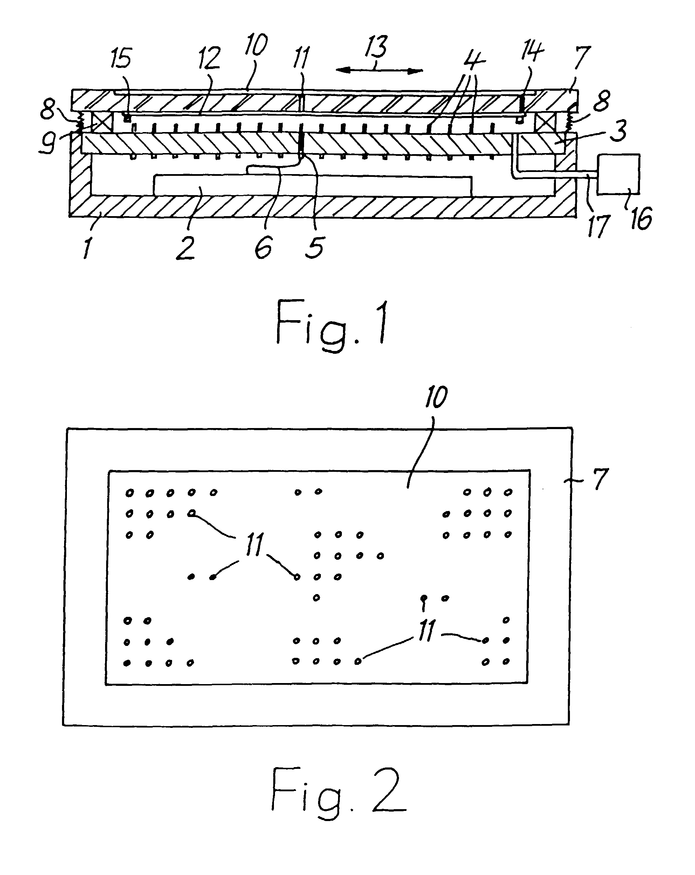

In einem kastenförmigen Gehäuse 1 mit rechteckiger Grundfläche ist eine in Form eines Blockes dargestellte Elektronik 2 angeordnet. In dieser "Elektronik" sind Schaltungen und Zusatzschaltungen enthalten, die zur Durchführung von Incircuit-Test und Funktionstest erforderlich sind. Da diese Schaltungen bekannt sind, wird hier nicht auf dieselben eingegangen. An der Oberkante des Gehäuses 1 befindet sich eine dasselbe dicht abdeckende Trägerplatte 3, in der eine Vielzahl von Kontaktnadeln 4 angeordnet ist. Die Kontaktnadeln 4 sind ebenfalls grundsätzlich bekannt. Sie sind in Hülsen 5 eingesetzt, die ihrerseits in der Trägerplatte 3 befestigt sind. In Fig. 1 ist der Einfachheit halber nur eine Hülse 5 eingezeichnet. Sie durchdringt die Trägerplatte 3. An ihrem in das Innere des Gehäuses 1 ragenden Ende kann ein elektrischer Leiter 6 zur Verbindung mit der Elektronik 2 angeschlossen sein. Die Kontaktnadeln 4 sind in den Hülsen 5 in axialer Richtung beweglich. Sie stehen unter Federeinwirkung. Es sind Kontaktnadeln 4 mit zwei unterschiedlichen Längen vorhanden, und zwar jeweils in einer vorgegebenen Anzahl.

Über der Trägerplatte 3 befindet sich mit Abstand zu derselben eine Deckplatte 7. Sie wird in ihrer aus Fig. 1 ersichtlichen Ruhestellung durch Federn 8 abgestützt, die rund um das Gehäuse 1 und auch an anderen Stellen vorhanden sind. Zwischen Trägerplatte 3 und Deckplatte 7 befindet sich eine umlaufende Dichtung 9. Die Deckplatte 7 hat außerdem mindestens eine Aufnahme 10, in welche eine zu prüfende Leiterkarte als Prüfling eingelegt werden kann. Die Deckplatte 7 ist mit einer der Anzahl der Kontaktnadeln 4 entsprechenden Anzahl von Durchgangsbohrungen 11 ausgerüstet, von denen ebenso wie für die Hülsen 5 in Fig. 1 nur eine eingezeichnet ist. Die Kontaktnadeln 4 können in die Durchgangsbohrungen 11 eindringen und so die Leiterkarte kontaktieren.

An der Unterseite der Deckplatte 7 ist ein Schieber 12 angebracht, der in Richtung des Doppelpfeils 13 zwischen zwei Endstellungen bewegbar ist. Dafür wird vorzugsweise ein Elektromotor 14 verwendet, beispielsweise ein Gleichstrommotor. Von dem Schieber 12 stehen auf einer Seite Distanzstücke 15 rechtwinklig ab, von denen in Fig. 1 nur zwei eingezeichnet sind.

Zur Vorrichtung gehört auch eine externe Einheit 16 zur Erzeugung von Unterdruck zwischen der Trägerplatte 3 und der Deckplatte 7. Dazu ist die Einheit 16 über einen Schlauch 17 mit dem Raum zwischen Trägerplatte 3 und Deckplatte 7 verbunden. Dieser Raum ist nach außen durch die Dichtung 9 abgedichtet. Außerdem sind die Hülsen 5 in der Trägerplatte 3 hermetisch dicht angeordnet.

Wenn eine Leiterkarte in die Aufnahme 10 gelegt ist, sind alle Durchgangsbohrungen 11 der Deckplatte 7 abgedeckt. Von der außerhalb des Gehäuses 1 angeordneten Einheit 16 kann dann Unterdruck erzeugt werden. Die Deckplatte 7 mit der Leiterkarte wird dadurch gegen die Wirkung der Federn 8 bis zu einer unteren Ebene nach unten gezogen, bis die Leiterkarte an allen Kontaktnadeln 4 mit ausreichendem Druck anliegt. Die Distanzstücke 15 sind dabei nicht wirksam. Sie greifen in Ausnehmungen der Trägerplatte 3 ein. In dieser unteren Ebene der Deckplatte 7 bzw. der Leiterkarte wird der Incircuit-Test durchgeführt.

Für den Funktionstest wird die Deckplatte 7 mit der Leiterkarte in eine andere Ebene bewegt, die über der unteren Ebene liegt. Dazu wird der Unterdruck vermindert, so daß die Federn 8 die Deckplatte 7 eine bestimmte Strecke nach oben drücken. In dieser neuen Position der Deckplatte 7 wird der Schieber 12 in seine zweite Endstellung bewegt. Bei erneuter Verstärkung des Unterdrucks wird die Deckplatte 7 wieder nach unten bewegt. Ihr Weg wird jetzt aber durch die Distanzstücke 15 begrenzt, die sich auf der Trägerplatte 3 abstützen. Die Leiterkarte liegt dadurch nur noch an den längeren, für den Funktionstest vorgesehenen Kontaktnadeln 4 mit ausreichendem Druck an.

Nach Beendigung der beiden Tests, die auch in umgekehrter Reihenfolge durchgeführt werden könnten, wird der Unterdruck aufgehoben. Die Deckplatte 7 geht in ihre aus Fig. 1 ersichtliche Ruhestellung zurück. Die Leiterkarte kann aus der Aufnahme 10 herausgenommen werden.

## Patentansprüche

1. Vorrichtung zum Prüfen von Leiterkarten und/oder Flachbaugruppen für elektrische Schaltungen, bei welcher in einem Gehäuse (1) mindestens eine mit Kontaktnadeln (4) unterschiedlicher Länge bestückte Trägerplatte (3) angeordnet ist, bei welcher in einer oberhalb der Trägerplatte liegenden Deckplatte (7) mindestens eine Aufnahme (10) für einen als Leiterkarte oder Flachbaugruppe ausgebildeten Prüfling angebracht ist, bei welcher eine Einheit (16) zur Erzeugung von Unterdruck zum Heranziehen des Prüflings an die Kontaktnadeln vorgesehen ist und bei welcher ein quer zur Bewegungsrichtung des Prüflings zwischen zwei Endstellungen bewegbarer, mit auf einer Seite rechtwinklig abstehenden Distanzstücken (15) ausgerüsteter Schieber (12) angebracht ist, durch welchen der Weg des durch Erzeugung des Unterdrucks aus seiner Ruhestellung bewegten Prüflings nach Maßgabe der unterschiedlichen Länge der Kontaktnadeln in zwei unterschiedlichen Ebenen begrenzbar ist, dadurch gekennzeichnet, daß der Schieber (12) an der Unterseite der die Aufnahme (10) für den Prüfling tragenden Deckplatte (7) angebracht ist.

## Claims

1. Device for the testing of printed circuit boards and/or flat modules for electrical circuits, in which at least one carrier plate (3) is arranged in a housing (1), the said carrier plate being fitted with contact needles (4) of differing lengths, in which at least one mounting (10) is fitted in a cover plate (7) located above the carrier plate, the said mounting being intended to accommodate a test specimen designed as a printer circuit board or flat module, in which a unit (16) is provided for creating a negative pressure to draw the test specimen into the contact needles, and in which a slide element (12) is located, capable of moving transversely to the direction of movement of the test specimen between two end positions, fitted with spacer pieces (16) projecting at right angles on one side, by means of which slide element the path of the test specimen, moved out of its position of rest by the generation of the negative pressure, can be limited in two different planes as determined by the differing length of the contact needles, characterised in that the slide element (12) is located on the under side of the cover plate (7) which carried the mounting (10) for the test specimen.

## Revendications

1. Dispositif servant à contrôler les cartes de circuits imprimés et ou les blocs fonctionnels plats de commutations électriques, comportant un boîtier (1) qui contient une plaque de support (3) équipée de broches de contact (4) de différentes longueurs, il comprend également une plaque de fermeture (7) située au-dessus de la plaque de support et pouvant recevoir au moins une carte imprimée ou un bloc fonctionnel plat à contrôler sur un support (10), le dispositif est également équipé d'un bloc (16) pour la production d'une dépression destinée à attirer l'objet à contrôler contre les broches de contact, et aussi d'un élément poussoir (12) qui se déplace perpendiculairement au sens de déplacement de l'objet à contrôler entre deux positions extrêmes et qui est équipé d'entretoises (15) dressées perpendiculairement au poussoir et qui permettent de positionner l'objet à contrôler lors de son déplacement provoqué par la dépression, sur deux écart différents qui correspondent au différentes longueurs des broches de contact, l'invention est caractérisée par le fait que le poussoir (12) est monté sur la face inférieure de la plaque de fermeture (7) qui comporte la plaque support (10) de réception de l'objet à contrôler.
